# EUROPÄISCHE PATENTSCHRIFT

(11) **EP 2 483 942 B1**
(45) Veröffentlichungstag und Bekanntmachung des Hinweises auf die Patenterteilung: **20.11.2013**
(21) Anmeldenummer: 09740839.7
(22) Anmeldetag: 29.09.2009
(51) Int. Cl.: H01L 41/22, B29C 45/14, B29C 45/16

(54) **Verfahren zur Herstellung eines piezoelektrischen Funktionsmoduls**
Method of fabricating a piezoelectric functional module
Procédé de fabrication d'un module fonctionnel piézoélectrique

(43) Veröffentlichungstag der Anmeldung: 08.08.2012
(73) Patentinhaber: Fraunhofer Gesellschaft zur Förderung der angewandten Forschung e.V., 80686 München (DE)
(72) Erfinder: KROLL, Lothar, 01324 Dresden (DE); ELSNER, Holg, 09127 Chemnitz (DE); HEINRICH, Michael, 09112 Chemnitz (DE); SCHÖNECKER, Andreas, 01705 Freital (DE)
(74) Vertreter: Pfenning, Meinig & Partner GbR
(86) Internationale Anmeldenummer: PCT/DE2009/001392
(87) Internationale Veröffentlichungsnummer: WO 2011/038703

(56) Entgegenhaltungen:
- EP-A2- 0 259 813
- WO-A1-95/03632
- WO-A1-2007/024038
- JP-A- 2001 086 594

## Beschreibung

Die Erfindung betrifft ein Verfahren zur Herstellung piezoelektrischer Funktionsmodule. Die Funktionsmodule sind dabei Verbundbauteile, bei denen piezoelektrische Elemente mit einer Polymermatrix verbunden sind.

Piezoelektrische Elemente werden für viele Anwendungen eingesetzt. Sie können dabei als Sensoren oder auch als Aktoren sowie als Generatoren oder Ultraschallwandler wirken. In Form von Verbunden mit anderen Stoffen oder Materialien werden sie an verschiedenen Bauteilen oder Aggregaten eingesetzt. Dies kann zur Erfassung von unterschiedlichen Messsignalen, die Diagnose, aber auch für eine gezielte Einflussnahme zur Dämpfung von Schwingungen der Fall sein.

Insbesondere im mobilen Einsatz ist der Leichtbau solcher Module gewünscht. Dabei ist es auch gewollt, dass piezoelektrische Module in andere Strukturbauteile eingebunden, mit diesen verbunden oder darin integriert sind. Problematisch ist dabei aber die jeweilige elektrische Kontaktierung der piezoelektrischen Elemente. Hierfür ist üblicherweise ein erhöhter Aufwand erforderlich.

Bei dreidimensionalen komplexen Geometrien müssen auch die elektrischen Leiterbahnstrukturen für eine Weiterkontaktierung entsprechend komplex ausgebildet sein, wenn ein Einsatz an einem weiteren Strukturelement bezweckt ist.

Neben keramischen Verbundbauelementen sind solche, bei denen ein Verbund der piezoelektrischen Elemente mit einem Polymer hergestellt worden ist, bekannt.

Dabei können unterschiedliche piezoelektrische Elemente, in Form von Stäben, Plättchen, Fasern in eine Polymermatrix eingebettet sein. Dies ist in WO 2005/096400 A1 oder auch in DE 196 50 885 B4 beschrieben.

Dabei werden solche piezoelektrischen Bauelemente als Keramik-Polymer-Verbund dadurch hergestellt, dass unterschiedlichste piezoelektrische Elemente in eine Form eingebracht werden und nachfolgend die Form mit einem aushärtbaren Polymer befüllt wird. Dabei soll unter Vakuumbedingungen gearbeitet und ggf. zusätzlich ein Zentrifugieren durchgeführt werden, um Gaseinschlüsse zu vermeiden und das Polymer zu verdichten.

Es liegt auf der Hand, dass der Herstellungsaufwand und die erforderliche Taktzeit hoch sind. Insbesondere der Aufwand für die Ausbildung elektrischer Kontaktanschlüsse sowie von außen zu den piezoelektrischen Elementen geführten elektrischen Verbindungen ist erheblich. Sie müssen dabei auch in einem weiteren zusätzlichen Verfahrensschritt nach Entnahme eines solchen Verbundbauteils aus der Form ausgebildet werden. Die Herstellung ist relativ unproduktiv. Dabei wirken sich die Herstellungskosten für die Formen und die langen Taktzeiten, die für das Befüllen und Aushärten erforderlich sind, negativ aus.

Weiterhin ist einer automatisierten Fertigung Grenzen gesetzt.

Außerdem sind in der WO 95/03632 A1 Piezokompositmaterialien beschrieben, die in einer Matrix keramische Stäbe enthalten.

Ähnliche piezokeramische Module sind auch aus JP 2001 086594 A bekannt.

Die EP 0 259 813 A2 betrifft ein Verfahren zur Herstellung eines Verbundwerkstoffes aus einem elektrisch leitfähigen polymeren und einem keramischen Werkstoff.

Es ist daher Aufgabe der Erfindung, piezoelektrische Funktionsmodule zur Verfügung zu stellen, die komplex ausgebildet sein können und flexibel und kostengünstig herstellbar sind.

Erfindungsgemäß wird diese Aufgabe mit einem Verfahren, das die Merkmale des Anspruchs 1 aufweist, gelöst. Vorteilhafte Ausgestaltungen der Erfindung sind mit im untergeordneten Anspruch bezeichneten Merkmalen realisierbar.

Ein erfindungsgemäß herstellbares piezoelektrisches Funktionsmodul ist ebenfalls als Verbundbauelement ausgebildet. Die piezoelektrischen Elemente sind mit einer Polymermatrix verbunden. Für diese Verbindung der piezoelektrischen Elemente werden ein elektrisch leitender polymerer Stoff und für einen elektrisch nicht leitenden Träger, als elektrischer Isolator, ein Polymer genutzt. Die piezoelektrischen Elemente sind mit dem elektrisch leitenden polymeren Stoff und/oder dem Träger formschlüssig verbunden. Mit dem elektrisch leitenden polymeren Stoff können elektrisch leitende Verbindungen zwischen und auch zu den piezoelektrischen Elementen ausgebildet werden.

Bei der Herstellung der erfindungsgemäßen Funktionsmodule wird so vorgegangen, dass in einem ersten Verfahrensschritt -

in ein vorab geschlossenes Kunststoffspritzgusswerkzeug der elektrisch leitende polymere Stoff oder das elektrisch nicht leitende Polymer von einer Seite eingespritzt wird, wobei in einer Alternative piezoelektrische Elemente bereits vorab in das Kunststoffspritzgusswerkzeug eingesetzt und darin in den gewünschten Positionen fixiert worden sein können. In einer weiteren Alternative, die allein, aber auch gemeinsam mit der zuerst genannten Alternative genutzt werden kann, können für die Ausbildung von Aufnahmen für piezoelektrische Elemente im Kunststoffspritzgusswerkzeug herausnehmbare Kerne oder ein dementsprechender Formeinsatz enthalten sein.

In einem weiteren sich daran anschließenden Verfahrensschritt - wird der jeweils andere polymere Stoff oder das Polymer in das Kunststoffspritzgusswerkzeug eingespritzt; dabei kann ein Teil eines zweigeteilten Kunststoffspritzgusswerkzeugs bewegt werden, so dass sich die Kavität innerhalb des Kunststoffspritzgusswerkzeugs vergrößert und mindestens ein Hohlraum vorhanden ist, der noch nicht mit piezoelektrischen Elementen, polymerem Stoff oder Polymer ausgefüllt ist. Dabei kann aus einer anderen Richtung in das Kunststoffspritzgusswerkzeug, beispielsweise von der gegenüberliegenden Seite, eingespritzt werden.

In diesem Verfahrensschritt können aber auch Kerne oder ein Formeinsatz nach dem Einspritzen des polymeren Stoffs oder des Polymers entfernt und die piezoelektrischen Elemente in die Aufnahmen eingeführt werden, bevor der jeweils andere polymere Stoff oder das Polymer von der anderen Seite in das Kunststoffspritzgusswerkzeug in Bereiche, die vorher von Kernen oder dem Formeinsatz ausgefüllt waren, eingespritzt wird.

In einem sich daran anschließenden Verfahrensschritt wird das Funktionsmodul entformt.

Ohne Entnahme aus dem Kunststoffspritzgusswerkzeug können zum einen die formschlüssige Verbindung und zum anderen auch elektrisch leitende Verbindungen mit dem elektrisch leitenden polymeren Stoff hergestellt werden.

Die bei der Erfindung einsetzbaren piezoelektrischen Elemente können stabförmig, als Fasern, Faserbündel, plattenförmig oder rohrförmig ausgebildet sein. Es können auch piezoelektrische Elemente, die an einer Oberfläche teilweise metallisiert sind, eingesetzt werden.

An einem erfindungsgemäß hergestellten Funktionsmodul können piezoelektrische Elemente in einer Reihenanordnung oder einer Reihen- und Spaltenanordnung vorhanden sein. Günstig ist es, die piezoelektrischen Elemente parallel zueinander anzuordnen. In diesem Fall können elektrisch leitende Verbindungen an zwei sich gegenüberliegend angeordneten Stirnseiten mit dem elektrisch leitenden polymeren Stoff für mehrere piezoelektrische Elemente gebildet sein. Dabei kann von den Stirnseiten jeweils ein Pol eines piezoelektrischen Elements elektrisch leitend angeschlossen sein.

Die piezoelektrischen Elemente können aus einem keramischen gesinterten Werkstoff, beispielsweise Bleizirkontitanat (PZT), gebildet sein.

Als Polymer, das den elektrisch isolierenden Träger bildet, kann ein Polymer, das ausgewählt ist aus PE, PP, POM und PA, eingesetzt werden.

Als ein elektrisch leitender polymerer Stoff kann ein Stoff eingesetzt werden, der intrinsisch elektrisch leitend ist. Dies kann beispielsweise Polyacetylen, Poly(para-phenylen), Polyphenylenvinylen, Polythiopen, Polyethylendioxythiopen, Polyanilin oder Polypyrrol sein.

Es kann in einem ansonsten elektrisch nicht leitenden Polymer ein elektrisch leitender Stoff enthalten sein. Dies kann beispielsweise Ruß, ein Metallpulver oder Kohlenstoffnanoröhrchen sein. In diesem Fall kann es vorteilhaft sein, jeweils das gleiche Polymer für die Ausbildung des Trägers und den polymeren Stoff einzusetzen.

Mit dem elektrisch nicht leitenden Polymer kann eine gesamte Fläche eines Funktionsmoduls gebildet worden sein, so dass diese Seite eine vollständig elektrisch isolierende Fläche bilden kann. Diese Seite eines Funktionsmoduls kann eine funktionelle Schutzschicht eines Moduls bilden.

Bei der Erfindung besteht außerdem die Möglichkeit, zusätzlich mindestens ein weiteres Funktionselement und/oder elektrisches Kontaktelement elektrisch leitend und stoff- und/oder formschlüssig mit dem elektrisch leitenden polymeren Stoff und/oder dem Polymer zu verbinden. Ein solches Funktionselement oder Kontaktelement kann ebenfalls über mit dem polymeren Stoff gebildete elektrische Verbindungen elektrisch leitend nach außen elektrisch kontaktiert werden. Eine elektrisch leitende Verbindung kann in dieser Form aber zu mindestens einem piezoelektrischen Element gebildet werden. Ein solches Kontaktelement kann auch nach außen geführt sein und dann die elektrisch leitende Verbindung innerhalb des Funktionsmoduls mit dem elektrisch leitenden polymeren Stoff insbesondere an schwer zugänglichen Bereichen ausbilden.

Funktionselemente können beispielsweise Beleuchtungselemente, ein Lichtwellenleiter, ein optisches Element, Generator, Kondensator, Transistor, Diode oder elektrischer Widerstand sein.

Dabei kann bei der erfindungsgemäßen Herstellung der Funktionsmodule mindestens in eine entsprechend ausgebildete Aufnahme, wie sie bereits für piezoelektrische Elemente erwähnt worden ist, mindestens ein weiteres Funktionselement eingesetzt und mit elektrisch leitendem polymeren Stoff, der in das Kunststoffspritzgusswerkzeug eingespritzt wird, elektrisch leitend verbunden werden. Die stoff- und/oder formschlüssige Verbindung kann mit dem polymeren Stoff und/oder dem elektrisch nicht leitenden Polymer durch das Kunststoffspritzgießen hergestellt werden.

Das Kunststoffspritzgusswerkzeug kann so ausgebildet sein, dass an einem Funktionsmodul in Bereichen, die mit dem elektrisch leitenden polymeren Stoff gebildet sind, Vertiefungen oder Erhebungen ausgebildet werden können. Solche Vertiefungen können z.B. Sacklöcher oder ähnlich geometrisch gestaltet sein. Nach dem Entformen können dann elektrisch leitende Kontaktelemente in Vertiefungen eingesetzt oder auf Erhebungen aufgesetzt und form- und kraftschlüssig in einer solchen Vertiefung oder an einer Erhebung gehalten werden. Ein Kontaktelement kann beispielsweise ein metallischer Stift oder eine Hülse sein. Diese können aber auch mechanische Schnittstellen darstellen, mit denen mehrere Funktionsmodule oder ein Funktionsmodul mit anderen Elementen mechanisch miteinander verbunden werden können.

Die Funktionsmodule können relativ klein in Mikrokunststoffspritztechnologie hergestellt werden.

Es besteht auch die Möglichkeit, ein wie bisher beschrieben hergestelltes Funktionsmodul nach dem Entformen in schmalere Streifen zu zerschneiden, so dass eine Vielzahl solcher Module erhalten werden kann, die jeweils gleich ausgebildet sein können. Bei der Erfindung können die Nachteile des Standes der Technik beseitigt werden und insbesondere die Produktivität bei der Herstellung deutlich erhöht werden.

Die bei den eingesetzten Polymeren vorhandene Risstoleranz kann für eine großflächige elektrische Kontaktierung genutzt werden.

Die eingesetzten Polymere und auch die geeigneten polymeren Stoffe können besonders geeignete Steifigkeiten für ein Funktionsmodul sichern. Dadurch kann die Handhabung und die Nutzung von keramischen piezoelektrischen Elementen, die biegesteif und auch spröde sind, erleichtert bzw. verbessert werden. Während der eigentlichen Umformung beim Kunststoffspritzgieβen wirken sich die elastischen Eigenschaften mit hohen möglichen Dehnungsraten positiv aus.

Die Steifigkeit kann einmal durch die Wahl der eingesetzten Polymere, in denen auch weitere Füllstoffe enthalten sein können, beeinflusst werden. Dies kann aber auch mittels einer beeinflussten Aushärtung oder der vollständigen Polymerisation der eingesetzten Polymere erreicht werden. Die Aushärtung oder Polymerisation kann durch Ultraschall, Bestrahlung mit UV- oder Infrarotstrahlung, aber auch auf chemischen Weg beeinflusst werden.

Die erfindungsgemäß hergestellten Funktionsmodule können mit den piezoelektrischen Elementen in metallische, polymere und hybride Strukturen in integrierter Form eingebettet werden.

Erfindungsgemäß hergestellte Funktionsmodule können in vereinheitlichten Fertigungsschritten hergestellt und dabei auch die jeweilige Konfiguration (Aktor, Sensor, Generator, Ultraschallwandler) berücksichtigt werden.

Sie können außerdem einfach und kostengünstig mit anderen Strukturelementen verbunden werden. Dies kann beispielsweise durch Kleben, Schmelzkleben oder Schmelzschweißen bzw. einer geeigneten konturierten Oberflächengestaltung für eine form- und kraftschlüssige Verbindung in komplementär ausgebildete Konturelemente an einem Strukturelement, mit dem ein Funktionsmodul so verbunden werden soll, erreicht werden.

Die elektrische Isolation, elektrische Kontaktierung und eine mögliche Weiterverarbeitung können durch Aufschmelzen der/des eingesetzten Polymere(s), als Basismaterial realisiert werden.

Mit der erfindungsgemäß einzusetzenden Kunststoffspritzgusstechnik können filigrane, dreidimensional verbundene elektrische Isolationen, elektrisch leitende Verbindungen und Kontaktierungen sowie auch eine Weiterkontaktierung nach außen erreicht werden. Eine Serienfertigung ist ebenfalls möglich.

Nachfolgend soll die Erfindung beispielhaft näher erläutert werden.

Dabei zeigen:
Figur 1 ein Beispiel eines erfindungsgemäß herstellbaren Funktionsmoduls in einer perspektivischen Darstellung und
Figur 2 in einer Explosionsdarstellung die einzelnen Elemente, aus denen das in Figur 1 gezeigte Beispiel besteht.

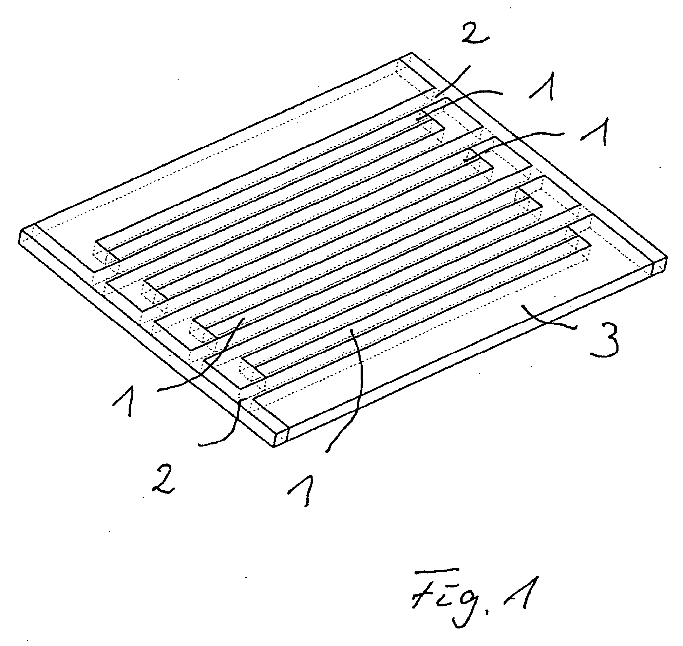

In Figur 1 ist ein Beispiel gezeigt, bei dem stabförmige piezoelektrische Elemente 1 aus gesintertem PZT mit einem elektrisch leitenden polymeren Stoff 2, der mit Polyethylen gebildet ist, in dem 25 % Ruß enthalten sind, umspritzt sind. Der elektrisch leitende polymere Stoff 2 bildet elektrisch leitende Verbindungen für die Kontaktierung von mehreren piezoelektrischen Elementen 1 und eine Kontaktierung nach auβen.

Die piezoelektrischen Elemente 1 sind parallel zueinander ausgerichtet und in einer Reihe angeordnet. Sie sind mit einem elektrisch nicht leitenden Polymer elektrisch voneinander isoliert. Der Träger 3 des Funktionsmoduls ist mit diesem Polymer gebildet. Als Polymer wurde Polyethylen eingesetzt.

In Figur 1 wird auch deutlich, wie elektrisch leitende Verbindungen mit dem polymeren Stoff 2 an jeweils einer Seite eines piezoelektrischen Elementes 1 angeordnet und parallel dazu bis an eine Stirnseite des Funktionsmoduls geführt sind. An den beiden Stirnseiten ist mit dem polymeren Stoff 2 eine elektrisch leitende Verbindung zwischen mehreren piezoelektrischen Elementen 1 hergestellt. Dadurch können alle piezoelektrischen Elemente 1 in gleicher Weise elektrisch betrieben oder bei einer Sensorfunktion, Generatorfunktion oder bei Ultraschallwandlern gleich genutzt werden, wenn symmetrische Verhältnisse und/oder gleiche piezoelektrische Elemente 1 vorhanden sind.

Die piezoelektrischen Elemente 1, der polymere Stoff 2 und der Träger 3 aus dem elektrisch nicht leitenden Polymer sind formschlüssig miteinander verbunden und die Herstellung erfolgte, wie im allgemeinen Teil der Beschreibung erläutert.

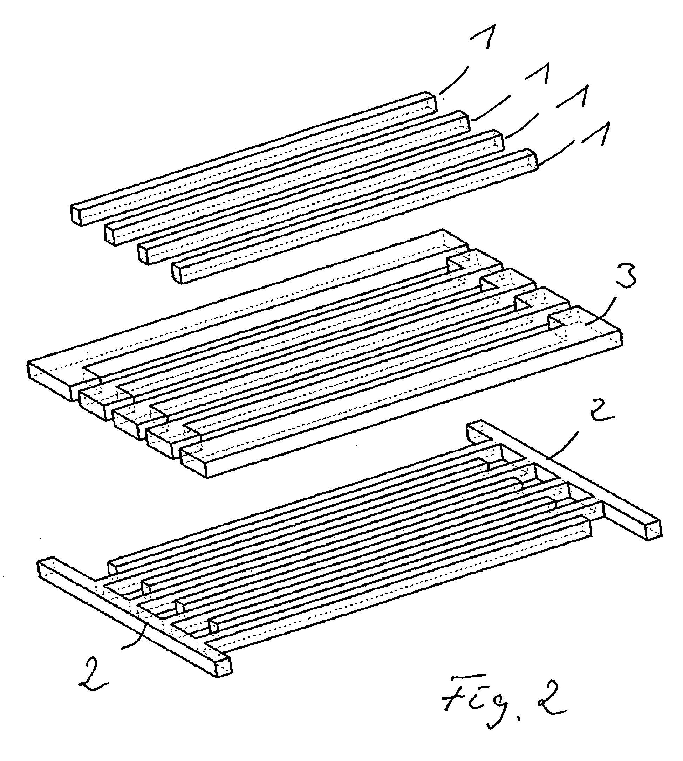

Die einzelnen Elemente 1 bis 3, mit denen das Funktionsmodul gebildet ist, sind in Figur 2 in einer Explosionsdarstellung gezeigt. Dabei wird deutlich, dass die gewählten Geometrien für die formschlüssige Verbindung und die für die bei der Nutzung erforderlichen elektrischen Eigenschaften geeignet sind.

## Patentansprüche

1. Verfahren zur Herstellung eines Funktionsmoduls, das als Verbundbauelement aus piezoelektrischen Elementen (1) und einer Polymermatrix ausgebildet ist, wobei die Polymermatrix aus einem als Träger (3) dienenden elektrisch nicht leitenden Polymer und einem die piezoelektrischen Elemente (1) kontaktierenden elektrisch leitenden polymeren Stoff (2) besteht, bei dem in einem ersten Schritt
i) in ein vorab geschlossenes Kunststoffspritzgusswerkzeug der elektrisch leitende polymere Stoff (2) oder das elektrisch nicht leitende Polymer von einer Seite eingespritzt wird, wobei die piezoelektrischen Elemente innerhalb des Kunststoffspritzwerkzeugs positioniert und fixiert sind und/oder für die Ausbildung von Aufnahmen für die piezoelektrischen Elemente (1) im Kunststoffspritzgusswerkzeug herausnehmbare Kerne oder ein dementsprechender Formeinsatz enthalten sind/ist,
in einem weiteren Schritt
ii) der jeweils andere polymere Stoff (2) oder das Polymer für die Ausbildung des Trägers (3) in das Kunststoffspritzgusswerkzeug eingespritzt wird, wobei vorher ein Teil eines zweigeteilten Kunststoffspritzgusswerkzeugs zur Vergrößerung der Kavität im Inneren des Kunststoffspritzgusswerkzeugs bewegt wird und/oder die Kerne oder der Formeinsatz nach dem Einspritzen des polymeren Stoffs (2) oder des Polymers entfernt und die piezoelektrischen Elemente (1) in die Aufnahmen eingeführt werden, so dass in diese(n) Bereich(e) der polymere Stoff (2) oder das Polymer eingespritzt wird und danach in einem weiteren Schritt
iii) das Funktionsmodul entformt wird.

2. Verfahren nach Anspruch 1, **dadurch gekennzeichnet, dass** im Schritt
ii) in mindestens eine entsprechend ausgebildete Aufnahme mindestens ein weiteres Funktionselement und/oder elektrisches Kontaktelement eingesetzt und mit dem polymeren Stoff (2) und/oder dem elektrisch nicht leitenden Polymer innerhalb des Kunststoffspritzgusswerkzeugs stoff- und/oder formschlüssig verbunden wird.

## Claims

1. Method for producing a functional module which is formed as a composite component of piezoelectric elements (1) and a polymer matrix, the polymer matrix consisting of an electrically non-conducting polymer serving as a carrier (3) and of an electrically conducting polymeric material (2) contacting the piezoelectric elements (1), in which method in a first step
i) the electrically conducting polymeric material (2) or the electrically non-conducting polymer is injected from one side into a plastics injection mould closed beforehand, the piezoelectric elements having being positioned and fixed inside the plastics injection mould and/or, for the formation of receptacles for the piezoelectric elements (1), removable cores or a corresponding mould insert being present in the plastics injection mould,
in a further step
ii) the respectively other polymeric material (2) or the polymer for the formation of the carrier (3) is injected into the plastics injection mould, a part of a two-part plastics injection mould being moved beforehand to enlarge the cavity inside the plastics injection mould and/or the cores or the mould insert being removed after the injection of the polymeric material (2) or the polymer and the piezoelectric elements (1) being inserted into the receptacles, so that the polymeric material (2) or the polymer is injected into this(these) region(s), and thereafter in a further step
iii) the functional module is removed from the mould.

2. Method according to Claim 1, **characterised in that** in step
ii) at least one further functional element and/or electrical contact element is inserted into at least one correspondingly formed receptacle and is connected to the polymeric material (2) and/or the electrically non-conducting polymer inside the plastics injection mould in a materially-bonded and/or formfitting manner.

## Revendications

1. Procédé de fabrication d'un module fonctionnel, qui est conçu comme un composant composite constitué d'éléments piézoélectriques (1) et d'une matrice polymère, la matrice polymère se composant d'un polymère électrique non conducteur servant de support (3) et d'un matériau polymère (2) électro-conducteur mettant en contact les éléments piézoélectriques (1), dans lequel, lors d'une première étape :
i) dans un outil d'injection de matière plastique préalablement fermé, le matériau polymère (2) électro-conducteur ou le polymère électrique non conducteur sont injectés d'un côté, les éléments piézoélectriques étant positionnés et fixés à l'intérieur de l'outil d'injection de matière plastique et/ou, pour la formation de logements pour les éléments piézoélectriques (1), des noyaux amovibles ou un insert de moulage correspondant est(sont) contenu(s) dans l'outil d'injection de matière plastique,
lors d'une étape suivante :
ii) respectivement, l'autre matériau polymère (2) ou le polymère pour la formation du support (3) est injecté dans l'outil d'injection de matière plastique, une partie d'un outil d'injection de matière plastique en deux parties étant préalablement déplacé pour agrandir la cavité à l'intérieur de l'outil d'injection de matière plastique et/ou les noyaux ou l'insert de moulage étant retirés après l'injection du matériau polymère (2) ou du polymère et les éléments piézoélectriques (1) étant introduits dans les logements, de sorte que, dans cette(ces) zone(s), le matériau polymère (2) ou le polymère est injecté, puis lors d'une étape suivante :
iii) le module fonctionnel est démoulé.

2. Procédé selon la revendication 1, **caractérisé en ce que**, à l'étape ii), dans au moins un logement conçu de manière correspondante, au moins un autre élément fonctionnel et/ou un élément de contact électrique est inséré et relié par liaison de matière et/ou par complémentarité de forme avec le matériau polymère (2) et/ou le polymère électrique non conducteur à l'intérieur de l'outil d'injection de matière plastique.
